# EUROPÄISCHE PATENTANMELDUNG

(11) **EP 2 725 880 A1**
(43) Veröffentlichungstag der Anmeldung: **30.04.2014**
(21) Anmeldenummer: 13185946.4
(22) Anmeldetag: 25.09.2013
(51) Int. Cl.: H05K 1/02, H05K 3/00, H05K 3/34

(54) **Leiterplatte**

(30) Priorität: 24.10.2012 DE 102012020838
(71) Anmelder: Schoeller-Electronics GmbH, 35083 Wetter / Hessen (DE)
(72) Erfinder: Berkel, Jan Hendrik, 7462 BR Rijssen (NL)
(74) Vertreter: Gottschald, Jan

(57) **Zusammenfassung**

Die Erfindung betrifft eine Leiterplatte zur Bestückung mit mindestens einem elektronischen Bauelement (2), wobei mindestens ein Wärmeleitelement (6) vorgesehen ist, das über eine Grenzschicht (7) mit einer Oberfläche (8) eines flächigen Leiterplattenkörpers (9) verbunden ist. Die Grenzschicht (7) besteht flächenweise aus einer elektrisch nichtleitenden Schicht (10) und flächenweise aus einer elektrisch leitenden Schicht (11), wobei die nichtleitende Schicht (10) zusammen mit dem Leiterplatten-körper (9) und dem Wärmeleitelement (6) mindestens einen Aufnahmeraum (12) mit einem taschenformigen Volumen für die leitende Schicht (11) bereitstellt.

## Beschreibung

Die Erfindung betrifft eine Leiterplatte zur Bestückung mit mindestens einem elektronischen Bauteil gemäß Anspruch 1 sowie ein Verfahren zur Herstellung einer solchen Leiterplatte gemäß Anspruch 11.

Aus dem Stand der Technik sind gedruckte elektronische Schaltungen bekannt, bei denen Leiterplatten mit elektronischen Bauelementen bestückt sind. Solche Leiterplatten können aus einer oder mehreren Einzellagen von glasfaserverstärkten, ausgehärteten Epoxidharz-Platten bestehen, die zur Ausbildung von Leiterbahnen ein- oder beidseitig kupferkaschiert sind. Diese Anordnung aus einer oder mehreren Einzellagen wird vorliegend als "Leiterplattenkörper" bezeichnet.

Eine bestückte und im Betrieb befindliche Leiterplatte ist wegen der relativ hohen Verlustleistung der darauf angeordneten elektronischen Bauelemente einer hohen Wärmeentwicklung unterworfen. Zur Ableitung der auf die Verlustleistung zurückgehende Wärme ist es bekannt, ein Wärmeleitelement in Form eines Metallkörpers vorzusehen. Das Wärmeleitelement besteht regelmäßig aus Kupfer oder einem vergleichbaren Material, das eine gute Wärmeleitfähigkeit aufweist. Das in der Leiterplatte vorgesehene Wärmeleitelement gewährleistet eine ausreichende Abfuhr der Verlustwärme von den elektronischen Bauelementen und verhindert somit einen kritischen Temperaturbereich für die Bauelemente und die Leiterplatte.

Neben der Wärmeleitung kommt dem Wärmeleitelement oft die Zusatzfunktion zu, eine Masseverbindung für das betreffende Bauelement bereitzustellen. Bei einer bekannten Anordnung steht das elektronische Bauelement durch eine Aussparung in dem Leiterplattenkörper hindurch in thermischem und elektrischem Kontakt mit dem Wärmeleitelement. Von besonderer Bedeutung ist dann die Tatsache, dass das Wärmeleitelement eine niederohmige elektrische Verbindung mit einer Masselage der Leiterplatte bereitstellt. Bei Hochfrequenzanordnungen ergibt sich dabei zusätzlich die Anforderung, den Massekontakt zwischen dem Wärmeleitelement und der Masselage der Leiterplatte möglichst in der Nähe des elektronischen Bauelements vorzusehen, so dass der Aufbau von Störfeldern unterdrückt wird. Die obige Masselage der Leiterplatte erstreckt sich meist über einen wesentlichen Teil der Fläche des Leiterplattenkörpers.

Bei der in Rede stehenden Leiterplatte ist das Wärmeleitelement über eine klebende Grenzschicht mit einer Oberfläche des Leiterplattenkörpers verbunden. Dabei kommt ein elektrisch und thermisch leitender Kleber zur Anwendung, der den elektrischen Kontakt zwischen dem Wärmeleitelement und der Masselage der Leiterplatte bereitstellt. Die leitende Grenzschicht erstreckt sich dabei großflächig über das Wärmeleitelement.

Problematisch bei der bekannten Leiterplatte ist die Tatsache, dass die großflächige Verwendung des leitfähigen Klebers kostspielig ist.

Der Erfindung liegt das Problem zugrunde, die bekannte Leiterplatte derart auszugestalten und weiterzubilden, dass eine kostengünstigere Herstellung möglich ist.

Das obige Problem wird durch eine Leiterplatte mit den Merkmalen von Anspruch 1 gelöst. Der vorschlagsgemäßen Lösung liegt zunächst die Überlegung zugrunde, die Grenzschicht gezielt flächenweise aus einer elektrisch nichtleitenden Schicht und flächenweise aus einer elektrisch leitenden Schicht aufzubauen. Damit ist es grundsätzlich möglich, die kostenintensive elektrisch leitende Schicht nur dort vorzusehen, wo sie insbesondere zur Herstellung eines Massekontakts benötigt wird.

Wesentlich ist nun die Erkenntnis, dass die nichtleitende Schicht genutzt werden kann, um einen Aufnahmeraum für die leitende Schicht bereitzustellen. Im Einzelnen bildet die nichtleitende Schicht zusammen mit dem Leiterplattenkörper und dem Wärmeleitelement mindestens einen Aufnahmeraum mit einem taschenförmigen Volumen für die leitende Schicht.

Mit der vorschlagsgemäßen Lösung ergeben sich zahlreiche Möglichkeiten für die Auslegung der leitenden Schicht. Insbesondere muss es sich bei der leitenden Schicht nicht um eine Klebeschicht handeln. Bei der bevorzugten Ausgestaltung gemäß Anspruch 2 handelt es sich bei der leitenden Schicht in einer Variante um eine schmelzbare Schicht, insbesondere um eine Lotschicht.

Bei der weiter bevorzugten Ausgestaltung gemäß Anspruch 3 hält sich die während eines noch zu erläuternden Lötprozesses aufgeschmolzene leitende Schicht durch Kapillarwirkung im Aufnahmeraum. Die hierfür einzuhaltende Taschenhöhe des Aufnahmeraums wird weiter vorzugsweise durch die Schichtdicke der nichtleitenden Schicht bestimmt.

Nach einer weiteren Lehre gemäß Anspruch 11, der eigenständige Bedeutung zukommt, wird ein Verfahren für die Herstellung einer Leiterplatte beansprucht.

Wesentlich dabei ist die Tatsache, dass die obige Grenzschicht für die Verbindung des Wärmeleitelements mit der Oberfläche des Leiterplattenkörpers erzeugt wird derart, dass die nichtleitende Schicht den erläuterten Aufnahmeraum mit einem taschenförmigen Volumen für die leitende Schicht bereitstellt.

Auf alle Ausführungen zu der vorschlagsgemäßen Leiterplatte, die geeignet sind, das Verfahren für die Herstellung dieser Leiterplatte zu beschreiben, darf verwiesen werden.

Im Folgenden wird die Erfindung anhand einer lediglich ein Ausführungsbeispiel darstellenden Zeichnung näher erläutert. In der Zeichnung zeigt
- Fig. 1: eine vorschlagsgemäße Leiterplatte in einer Explosionsdarstellung,
- Fig. 2: die Leiterplatte gemäß Fig. 1 in einem vertikalen Schnitt,
- Fig. 3: das Wärmeleitelement und die nichtleitende Schicht der Leiterplatte gemäß Fig. 1 in einem perspektivischen Ausschnitt.

Die in der Zeichnung dargestellte Leiterplatte 1 ist bestimmungsgemäß mit mindestens einem elektronischen Bauelement 2 bestückbar. Bei dem dargestellten Bauelement 2 handelt es sich um einen integrierten Schaltkreis 3, der auf einem Metallplättchen 4 angeordnet ist. Das Metallplättchen 4 dient einerseits der Massekontaktierung und andererseits der Ableitung der auf die Verlustleistung des Bauelements 2 zurückgehenden Wärme. Das Bauelement 2 ist ferner mit Kontaktzungen 5 ausgestattet, die der elektrischen Kontaktierung des integrierten Schaltkreises 3 dienen.

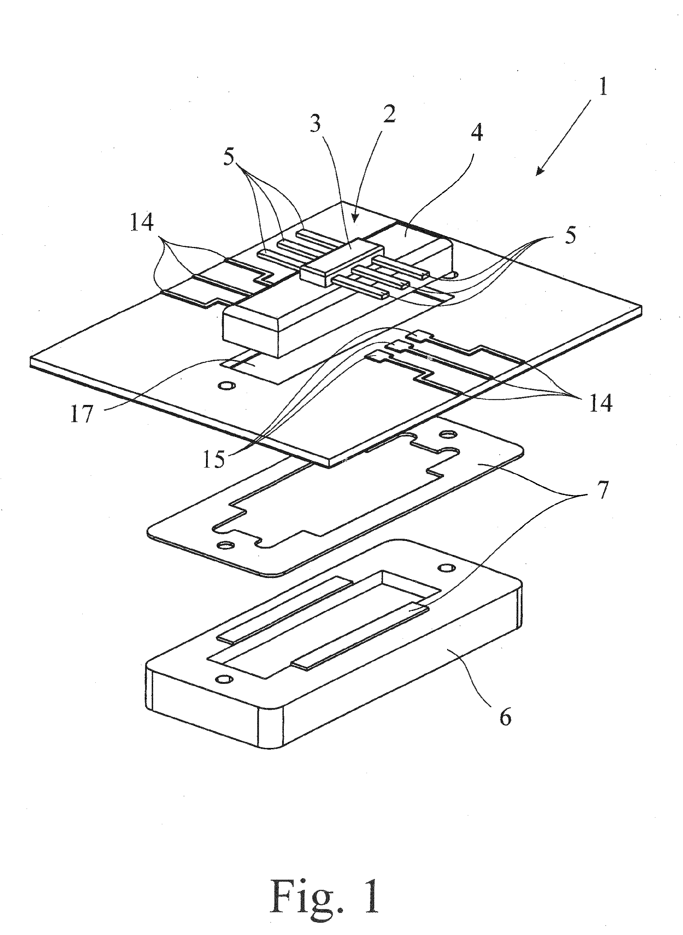

Fig. 1 zeigt ferner ein Wärmeleitelement 6, das hier und vorzugsweise aus Metall, insbesondere aus Kupfer, besteht. Grundsätzlich sind hier alle Materialien anwendbar, die eine gute Wärmeleitfähigkeit aufweisen.

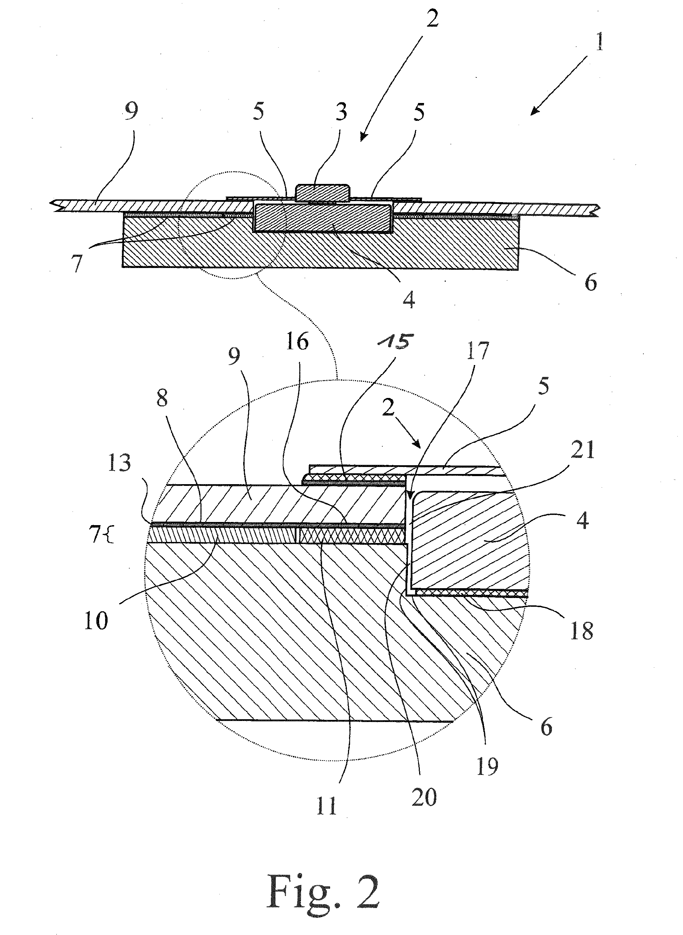

Es lässt sich der Darstellung gemäß Fig. 2 entnehmen, dass das Wärmeleitelement 6 über eine Grenzschicht 7 mit einer Oberfläche 8 eines flächigen Leiterplattenkörpers 9 verbunden ist. Bei dem Leiterplattenkörper 9 handelt es sich, wie oben erläutert, um die flächige Anordnung einer oder mehrerer Einzellagen, die ein- oder beidseitig zur Ausbildung von Leiterbahnen kupferkaschiert sein können.

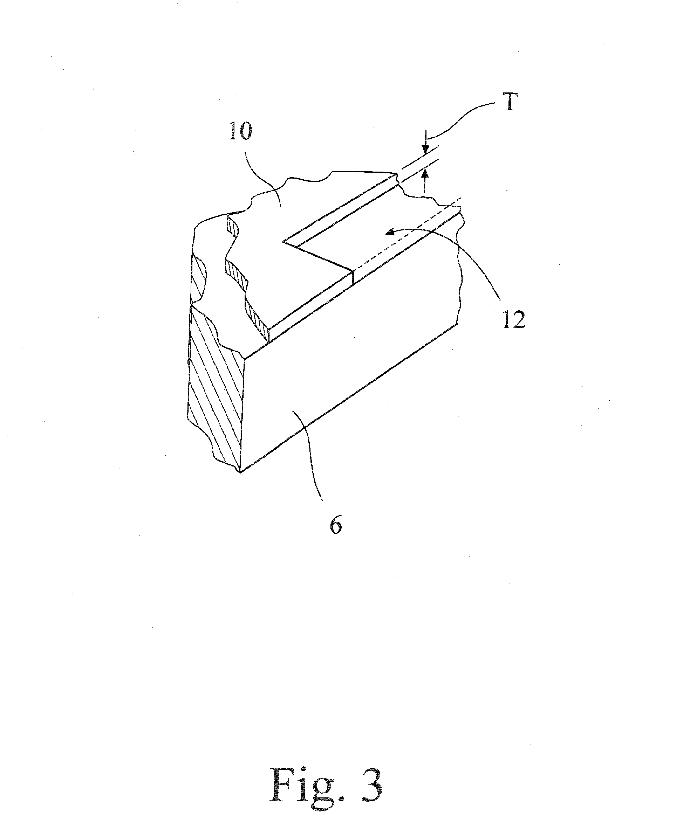

Der Ausgestaltung der Grenzschicht 7 zwischen dem Wärmeleitelement 6 und der Oberfläche 8 des Leiterplattenkörpers 9 kommt vorliegend besondere Bedeutung zu. Wesentlich ist, dass die Grenzschicht 7 flächenweise aus einer elektrisch nichtleitenden Schicht 10 und flächenweise aus einer elektrisch leitenden Schicht 11 besteht. Dabei ist die Anordnung so getroffen, dass die nichtleitende Schicht 10 zusammen mit dem Leiterplattenkörper 9 und dem Wärmeleitelement 6 mindestens einen Aufnahmeraum 12 (Fig. 3) mit einem taschenförmigen Volumen für die leitende Schicht 11 bereitstellt. Interessant dabei ist die Tatsache, dass die ohnehin vorgesehene, nichtleitende Schicht 10 zusätzlich dafür genutzt wird, einen Aufnahmeraum 12 für die leitende Schicht 11 zu definieren. Der Aufnahmeraum 12 kann vollständig geschlossen oder, wie in Fig. 2 gezeigt, zu einer Seite hin, in Fig. 2 nach rechts, offen sein.

Grundsätzlich kann es vorgesehen sein, dass die nichtleitende Schicht 10 und die leitende Schicht 11 im Wesentlichen nahtlos ineinander übergehen. Denkbar ist aber auch, dass zumindest abschnittsweise ein Freivolumen zwischen den beiden Schichten 10, 11 vorgesehen ist.

Es wurde weiter oben erläutert, dass die vorschlagsgemäße Lösung ganz neue Möglichkeiten für die Auslegung der leitenden Schicht 11 eröffnet. In einer besonders bevorzugten Ausgestaltung handelt es sich bei der leitenden Schicht 11 um eine schmelzbare Schicht, insbesondere um eine Lotschicht, die in einem noch zu erläuternden Lötprozess zur Massekontaktierung des Wärmeleitelements 6 aufgeschmolzen werden kann.

Die Lotschicht kann beispielsweise als Metallpaste, als Metallfolie o. dgl. vorgesehen sein, die bei der noch zu erläuternden Herstellung der Leiterplatte 1 zur Massekontaktierung aufgeschmolzen wird.

Denkbar ist für die Realisierung der leitenden Schicht 11 aber auch die Verwendung von Leitkleber, elektrisch leitenden Polymeren, elektrisch leitfähig gefüllten Polymeren, kohlenstoffbasierten Werkstoffen, Sinterwerkstoffen oder Infiltrationswerkstoffen.

Auch für die Realisierung der nichtleitenden Schicht 10 sind zahlreiche Varianten denkbar. Hier und vorzugsweise handelt es sich bei der nichtleitenden Schicht 10 um eine thermisch aktivierbare Klebefolie, die bei der noch zu erläuternden Herstellung der Leiterplatte 1 durch Einwirkung von Aktivierungswärme aktiviert wird. Vorteilhaft bei einer solchen Klebefolie ist die Tatsache, dass weitgehend beliebige Formgestaltungen möglich sind, da eine solche Klebefolie auf einfache Weise in Form gestanzt werden kann. Gleichzeitig ist eine solche Klebefolie im noch nicht aktivierten Zustand aufgrund einer gewissen Formstabilität gut handhabbar.

Dadurch, dass der Aufnahmeraum 12 von der Oberfläche 8 des Leiterplattenkörpers 9 einerseits und von dem Wärmeleitelement 6 andererseits begrenzt wird, lässt sich die Taschenhöhe T des Aufnahmeraums 12 (Fig. 3) leicht durch die dazwischenliegende nichtleitende Schicht 10 einstellen. Interessant ist dabei vor allem eine Ausgestaltung, bei der die Taschenhöhe T des Aufnahmeraums 12 so gering ist, dass die leitende Schicht 11 bei der noch zu erläuternden Herstellung der Leiterplatte 1 in ihrem noch flüssigen, insbesondere aufgeschmolzenen Zustand durch Kapillarwirkung im Aufnahmeraum 12 gehalten wird.

Vorzugsweise ist die Anordnung so getroffen, dass dies für jegliche Orientierung der Leiterplatte 1 gilt. Denkbar ist aber auch, dass die Anordnung so getroffen ist, dass die leitende Schicht 10 in ihrem flüssigen, insbesondere aufgeschmolzenen Zustand nur bei horizontal ausgerichteter Leiterplatte 1 durch Kapillarwirkung im Aufnahmeraum 12 gehalten wird.

Die Taschenhöhe T des Aufnahmeraums 12 kann in Abhängigkeit von der Auslegung der elektrisch leitenden Schicht 11 variieren. Sofern es sich bei der elektrisch leitenden Schicht 11 um ein schmelzbares Lotmaterial handelt, ist die Taschenhöhe T vorzugsweise kleiner als 0,5 mm, vorzugsweise kleiner als 0,1 mm.

Grundsätzlich kann die leitende Schicht 11 der Verbindung des Wärmeleitelements 6 mit irgendeinem elektrischen Leiterplattenpotential dienen. Hier und vorzugsweise ist es allerdings so, dass die leitende Schicht 11 eine Masseverbindung zwischen dem Wärmeleitelement 6 und einer Masselage 13 des Leiterplattenkörpers 9 bereitstellt. Bei der Masselage 13 kann es sich um eine kupferkaschierte Masselage handeln, die sich über den gesamten Leiterplattenkörper 9 erstreckt, wie in der Zeichnung gezeigt. Grundsätzlich kann die Masselage 13 aber auch nach Art einer Leiterbahn ausgebildet sein.

Bei dem dargestellten und insoweit bevorzugten Ausführungsbeispiel ist im bestückten Zustand der Leiterplatte 1 mindestens ein elektronisches Bauelement 2, hier und vorzugsweise genau ein elektronisches Bauelement 2, elektrisch an dem Wärmeleitelement 6 und an mindestens einer Signal-Leiterbahn 14, hier und vorzugsweise an insgesamt sechs Signal-Leiterbahnen 14, des Leiterplattenkörpers 9 kontaktiert. Weiter ist das Wärmeleitelement 6 elektrisch über die leitende Schicht 11 an einer Masselage 13 des Leiterplattenkörpers 9 kontaktiert, so dass die Masserückleitung des Bauelements 2 sichergestellt ist. Insbesondere bei Hochfrequenzanwendungen ist es, wie oben angesprochen, vorteilhaft, wenn die Masserückführung in unmittelbarer Nähe zu dem Bauelement 2 erfolgt, so dass die Entstehung elektromagnetischer Strahlung unterdrückt wird. Um dies zu gewährleisten, ist es hier und vorzugsweise vorgesehen, dass mindestens einem Signalkontakt 15 auf der Oberseite des Leiterplattenkörpers 9 ein Masse-Kontakt 16 auf der Unterseite des Leiterplattenkörpers 9 gegenüberliegt.

Die Begriffe "Signal-Leiterbahn" und "Signal-Kontakt" sind vorliegend weit zu verstehen und umfassen alle Leiterbahnen und Kontakte, die ein elektrisches Potential gegenüber dem Massepotential führen können.

Bei dem dargestellten und insoweit bevorzugten Ausführungsbeispiel ist es so, dass das Wärmeleitelement 6 und der Leiterplattenkörper 9 im Bereich der Grenzschicht 7 plan ausgestaltet sind. Denkbar ist aber auch, dass dort beliebige Oberflächentopographien vorgesehen sind, insbesondere um die Auslegung des Aufnahmeraums 12 zu beeinflussen.

Fig. 1 zeigt, dass der Leiterplattenkörper 9 eine Aussparung 17 für die Aufnahme eines elektronischen Bauelements 2 aufweist. Denkbar ist, dass mehrere Aussparungen 17 vorgesehen sind, und/oder, dass eine Aussparung 17 mehrere elektronische Bauelemente 2 aufnimmt. Alternativ kann es vorgesehen sein, dass die Aussparung der Aufnahme des Wärmeleitelements 6 dient. In diesem Fall wäre das in Fig. 1 dargestellte Wärmeleitelement 6 mit einem Sockel ausgestattet, der zumindest zum Teil durch die Aussparung 17 hindurchragen würde. Die Verbindung des Wärmeleitelements 6 über die angesprochene Grenzschicht 7 würde sich dadurch allerdings nicht verändern.

In besonders bevorzugter Ausgestaltung ist es so, dass im bestückten Zustand der Leiterplatte 1 ein der Aussparung 17 zugeordnetes elektrisches Bauelement 2 im Bereich der Aussparung 17 in wärmeleitendem und elektrischem Kontakt mit dem Wärmeleitelement 6 steht. Hier und vorzugsweise ragt das elektronische Bauelement 2 durch die Aussparung 17 hindurch, um in entsprechenden Kontakt mit dem Wärmeleitelement 6 zu kommen. Fig. 2 zeigt, dass das elektronische Bauelement 2 in flächiger Anlage mit dem Wärmeleitelement 6 steht. Dabei ist weiter vorzugsweise eine Lotschicht 18 zwischen dem Wärmeleitelement 6 und dem Bauelement 2 vorgesehen.

Das Wärmeleitelement 6 ist bei dem dargestellten und insoweit bevorzugten Ausführungsbeispiel mit einer wannenartigen Ausformung 19 ausgestattet, die der Aufnahme des elektronischen Bauelements 2 dient. Die Realisierung einer solchen wannenartigen Ausformung 19 ist eine Alternative zu der oben angesprochenen sockelartigen Ausformung des Wärmeleitelements 6.

Wie oben angesprochen, ist vor allem bei Hochfrequenzanwendungen dafür zu sorgen, dass die Masserückführung in unmittelbarer Nähe zu dem Bauelement 2 gelegen ist. Entsprechend wird vorgeschlagen, dass der Aufnahmeraum 12 für die leitende Schicht 11 im Bereich der Aussparung 17 gelegen ist. Interessant bei dem in Fig. 2 dargestellten und insoweit bevorzugten Ausführungsbeispiel ist die Tatsache, dass der Aufnahmeraum 12 für die leitende Schicht 11 sogar ganz am Rande der Aussparung 17 gelegen ist, so dass der Aufnahmeraum 12 einseitig zu der Aussparung 17 hin offen ist. Damit ist sichergestellt, dass die Masserückführung tatsächlich so nah wie möglich am Bauelement 2 gelegen ist. Hier zeigt sich die oben angesprochene Nutzung der Kapillarwirkung im Aufnahmeraum 12 als besonders vorteilhaft. Ohne diese Kapillarwirkung bestünde bei der in Fig. 2 dargestellten Ausgestaltung die Gefahr, dass die leitfähige Schicht 11 in ihrem flüssigen Zustand durch einen Spalt 20 zwischen dem Bauelement 2 und dem Wärmeleitelement 6 hindurch in die wannenartige Ausformung 19 fließen könnte. In diesem Fall würde das für den Massekontakt erforderliche Lot im Aufnahmeraum 12 fehlen, so dass es im Ergebnis zu einer Funktionsstörung kommen würde. Ferner bestünde die Gefahr, getrieben wiederum durch Kapillarwirkung, dass ein Teil der elektrisch leitenden Schicht 11 in ihrem flüssigen Zustand durch einen Spalt 21 zwischen dem Bauelement 2 und dem Leiterplattenkörper 9 zu den Kontaktzungen 5 fließen könnte.

Im Ergebnis ist die Kapillarwirkung, die die leitende Schicht 11 im Aufnahmeraum 12 hält, so auszulegen, dass sie die Kapillarwirkung, die die leitende Schicht 11 aus dem Aufnahmeraum 12 in Fig. 2 nach oben "zieht", überwiegt.

Nach einer weiteren Lehre, der ebenfalls eigenständige Bedeutung zukommt, wird ein Verfahren für die Herstellung einer vorschlagsgemäßen Leiterplatte 1 beansprucht. Auf alle Ausführungen zu der vorschlagsgemäßen Leiterplatte 1 darf insoweit verwiesen werden.

Wesentlich nach dieser weiteren Lehre ist, dass die Grenzschicht 7 für die Verbindung des Wärmeleitelements 6 mit der Oberfläche 8 des flächigen Leiterplattenkörpers 9 erzeugt wird derart, dass die Grenzschicht 7 flächenweise aus einer elektrisch nichtleitenden Schicht und flächenweise aus einer elektrisch leitenden Schicht 11 besteht. Wesentlich dabei ist die Tatsache, dass die Grenzschicht 7 so aufgebaut wird, dass die nichtleitende Schicht 10 zusammen mit der Oberfläche 8 des Leiterplattenkörpers 9 und dem Wärmeleitelement 6 mindestens einen Aufnahmeraum 12 mit einem taschenförmigen Volumen für die leitende Schicht 11 bereitstellt.

Vorzugsweise wird zur Erzeugung der Grenzschicht 7 ein Teil der leitenden Schicht 11 auf das Wärmeleitelement 6 aufgebracht. Dies ist in Fig. 1 dargestellt. Bei dieser Aufbringung handelt es sich vorzugsweise um eine haftende Aufbringung. Für den Fall, dass es sich bei der elektrisch leitenden Schicht 11 um eine Metallfolie handelt, die aufschmelzbar ist, ist es denkbar, dass die Metallfolie durch eine Art Laserschweißverfahren haftend auf das Wärmeleitelement 6 aufgebracht wird. Denkbar ist aber auch, dass die Metallfolie klebend aufgebracht wird.

Grundsätzlich ist es denkbar, dass die leitende Schicht 11 auf den Leiterplattenkörper 9, vorzugsweise haftend, aufgebracht wird. Denkbar ist in diesem Zusammenhang auch, dass die leitende Schicht 11 im Rahmen des Herstellungsprozesses für den Leiterplattenkörper 9 haftend aufgebracht wird.

Die Aufbringung der leitenden Schicht 11 kann erfolgen, bevor oder nachdem die nichtleitende Schicht 10 auf das Wärmeleitelement 6 und/oder den Leiterplattenkörper 9 aufgebracht wird. Bei dem in Fig. 1 dargestellten Fall könnte die Klebefolie auf dass die leitende Schicht 11 bereits tragende Wärmeleitelement 6 aufgelegt werden. Alternativ wäre es denkbar, die Klebefolie auf den Leiterplattenkörper 9 aufzubringen, sofern entsprechende Zentriermechanismen vorgesehen sind.

Für die Aufbringung der nichtleitenden Schicht 10 und der leitenden Schicht 11 sind je nach Materialauswahl zahlreiche Varianten möglich. Darunter fallen beispielsweise das Dispensen, Drucken, Heften über thermische Prozesse (Löten, Ultraschalllöten, Schweißen, Mikrowellenschweißen etc.), Heften über optische Prozesse wie Lasern o. dgl., Sprühen, mechanische Verbindungsprozesse (Pressen, Klemmen, Krimpen), chemische Prozesse, Sintern, Kleben oder Spattern.

Nach der Aufbringung der nichtleitenden Schicht 10 einerseits und der leitenden Schicht 11 andererseits wird das Wärmeleitelement 6 mit dem Leiterplattenkörper 9 über die resultierende Grenzschicht 7 verbunden.

In besonders bevorzugter Ausgestaltung erfolgt die Verbindung des Wärmeleitelements 6 mit dem Leiterplattenkörper 9 unter Einwirkung von Aktivierungswärme. Vorzugsweise ist dieser Prozess auch mit einem Pressvorgang in Fügerichtung verbunden.

Wie schon angedeutet, handelt es sich bei der nichtleitenden Schicht 10 vorzugsweise um einen thermisch aktivierbaren Kleber, insbesondere um eine thermisch aktivierbare Klebefolie. Dann ist es so, dass die obige Aktivierungswärme den Kleber bzw. die Klebefolie aktiviert, so dass eine Klebeverbindung zwischen dem Wärmeleitelement 6 und dem Leiterplattenkörper 9 hergestellt ist. Interessant dabei ist die Tatsache, dass die Aktivierungswärme vorzugsweise so gering ist, dass sie die leitende Schicht 11 noch nicht aufschmilzt.

Das Ergebnis der bisherigen Prozessschritte ist eine Leiterplatte 1, an der ein Wärmeleitelement 6 befestigt ist. Eine für den bestimmungsgemäßen Gebrauch vorgesehene leitende Verbindung zwischen dem Wärmeleitelement 6 und dem Leiterplattenkörper 9 ist über die leitende Schicht 11 regelmäßig noch nicht vorhanden. Ferner ist die Leiterplatte 1 in diesem Stadium unbestückt.

In einem anschließenden Schritt wird die Leiterplatte 1 nun mit dem mindestens einen elektronischen Bauelement 2 bestückt und in einem Lötprozess gelötet. Bei dem Lötprozess kann es sich um einen Reflow-Lötprozess, einen Dampfphasen-Lötprozess, einen Wellenlötprozess, einen Selektiv-Lötprozess o. dgl. handeln. Wesentlich dabei ist die Tatsache, dass während des Lötprozesses die leitende Schicht 11 durch die auf den Lötprozess zurückgehende Wärmeeinwirkung aufgeschmolzen wird und eine Lötverbindung mit der Masselage 13 einerseits und dem Wärmeleitelement 6 andererseits eingeht. Zu diesem Zeitpunkt erreicht die leitende Schicht 11 ihren oben verschiedentlich angesprochenen flüssigen Zustand, in dem die ebenfalls bereits angesprochene Kapillarwirkung innerhalb des Aufnahmeraums 12 dafür sorgt, dass die leitende Schicht 11 im Aufnahmeraum 12 verbleibt.

Im Rahmen des obigen Lötprozesses wird auch das Metallplättchen 4 des Bauelements 2 an den Boden der wannenartigen Ausformung 19 des Wärmeleitelements 6 gelötet. Das hierfür erforderliche Lot kann beispielsweise beim Bestücken des Bauelements 2 in Form einer Lötpaste o. dgl. in die wannenartige Ausformung 19 eingebracht werden.

Es darf noch darauf hingewiesen werden, dass die nichtleitende Schicht 10 und die leitende Schicht 11 jeweils mehrere Teilschichten aufweisen können, also selbst mehrschichtig ausgestaltet sein können. Ferner darf darauf hingewiesen werden, dass die Grenzschicht 7 nicht nur die obige nichtleitende Schicht 10 und leitende Schicht 11, sondern auch weitere Schichten aufweisen kann.

Schließlich darf darauf hingewiesen werden, dass die nichtleitende Schicht 10 und die leitende Schicht 11 jeweils thermisch leitend oder thermisch nichtleitend ausgestaltet sein können.

## Patentansprüche

1. Leiterplatte zur Bestückung mit mindestens einem elektronischen Bauelement (2), wobei mindestens ein Wärmeleitelement (6) vorgesehen ist, das über eine Grenzschicht (7) mit einer Oberfläche (8) eines flächigen Leiterplattenkörpers (9) verbunden ist, wobei die Grenzschicht (7) flächenweise aus einer elektrisch nichtleitenden Schicht (10) und flächenweise aus einer elektrisch leitenden Schicht (11) besteht, wobei die nichtleitende Schicht (10) zusammen mit dem Leiterplattenkörper (9) und dem Wärmeleitelement (6) mindestens einen Aufnahmeraum (12) mit einem taschenförmigen Volumen für die leitende Schicht (11) bereitstellt.

2. Leiterplatte nach Anspruch 1, **dadurch gekennzeichnet, dass** die leitende Schicht (11) aus einer schmelzbaren Schicht, insbesondere aus einer Lotschicht, besteht, und/oder, dass die nichtleitende Schicht (10) aus einer thermisch aktivierbaren Klebefolie besteht.

3. Leiterplatte nach Anspruch 1 oder 2, **dadurch gekennzeichnet, dass** die Taschenhöhe (T) des Aufnahmeraums (12) so gering ist, dass während der Herstellung der Leiterplatte (1) die noch flüssige, insbesondere aufgeschmolzene leitende Schicht (11) durch Kapillarwirkung im Aufnahmeraum (12) gehalten wird, vorzugsweise, dass die Taschenhöhe (T) des Aufnahmeraums (12) durch die Schichtdicke der nichtleitenden Schicht (10) bestimmt ist.

4. Leiterplatte nach einem der vorhergehenden Ansprüche, **dadurch gekennzeichnet, dass** die leitende Schicht (11) eine Masseverbindung zwischen dem Wärmeleitelement (6) und einer Masselage (13) des Leiterplattenkörpers (9) bereitstellt.

5. Leiterplatte nach einem der vorhergehenden Ansprüche, **dadurch gekennzeichnet, dass** im bestückten Zustand der Leiterplatte (1) mindestens ein elektronisches Bauelement (2) elektrisch an dem Wärmeleitelement (6) und an mindestens einer Signal-Leiterbahn (14) des Leiterplattenkörpers (9) kontaktiert ist und dass das Wärmeleitelement (6) elektrisch über die leitende Schicht (11) an einer Masselage (13) des Leiterplattenkörpers (9) kontaktiert ist, vorzugsweise, dass mindestens einem Signal-Kontakt (15) auf der Oberseite des Leiterplattenkörpers (9) ein Masse-Kontakt (16) auf der Unterseite des Leiterplattenkörpers (9) gegenüberliegt.

6. Leiterplatte nach einem der vorhergehenden Ansprüche, **dadurch gekennzeichnet, dass** der Leiterplattenkörper (9) mindestens eine Aussparung (17) für die Aufnahme eines elektronischen Bauelements (2) oder für die Aufnahme des Wärmeleitelements (6) aufweist.

7. Leiterplatte nach einem der vorhergehenden Ansprüche, **dadurch gekennzeichnet, dass** im bestückten Zustand der Leiterplatte (1) ein der Aussparung (17) zugeordnetes elektronisches Bauelement (2) im Bereich der Aussparung (17), insbesondere durch die Ausnehmung (17) hindurch, in wärmeleitendem und elektrischem Kontakt mit dem Wärmeleitelement (6) steht, vorzugsweise, dass das elektronische Bauelement (2) in flächiger Anlage mit dem Wärmeleitelement (6) steht.

8. Leiterplatte nach einem der vorhergehenden Ansprüche, **dadurch gekennzeichnet, dass** das Wärmeleitelement (6) eine wannenartige Ausformung (19) für die Aufnahme des elektronischen Bauelements (2) aufweist.

9. Leiterplatte nach einem der vorhergehenden Ansprüche, **dadurch gekennzeichnet, dass** der Aufnahmeraum (12) für die leitende Schicht (11) im Bereich der Aussparung (17) gelegen ist.

10. Leiterplatte nach einem der vorhergehenden Ansprüche, **dadurch gekennzeichnet, dass** der Aufnahmeraum (12) für die leitende Schicht (11) am Rande der Aussparung (17) gelegen ist, so dass der Aufnahmeraum (12) einseitig zu der Aussparung (17) hin offen ist.

11. Verfahren für die Herstellung einer Leiterplatte (1), wobei eine Grenzschicht (7) für die Verbindung eines Wärmeleitelements (6) mit einer Oberfläche (8) eines flächigen Leiterplattenkörpers (9) erzeugt wird derart, dass die Grenzschicht (7) flächenweise aus einer elektrisch nichtleitenden Schicht (10) und flächenweise aus einer elektrisch leitenden Schicht (11) besteht und die nichtleitende Schicht (10) zusammen mit der Oberfläche (8) des Leiterplattenkörpers (9) und dem Wärmeleitelement (6) mindestens einen Aufnahmeraum (12) mit einem taschenförmigen Volumen für die leitende Schicht (11) bereitstellt.

12. Verfahren nach Anspruch 11, **dadurch gekennzeichnet, dass** zur Erzeugung der Grenzschicht (7) zumindest ein Teil der leitenden Schicht (11) auf das Wärmeleitelement (6) und/oder auf den Leiterplattenkörper (9), vorzugsweise haftend, aufgebracht wird, bevor oder nachdem die nichtleitende Schicht (10) auf das Wärmeleitelement (6) und/oder den Leiterplattenkörper (9) aufgebracht wird und dass anschließend das Wärmeleitelement (6) mit dem Leiterplattenkörper (9) über die Grenzschicht (7) verbunden wird.

13. Verfahren nach Anspruch 11 oder 12, **dadurch gekennzeichnet, dass** die Verbindung des Wärmeleitelements (6) mit dem Leiterplattenkörper (9) unter Einwirkung von Aktivierungswärme erfolgt, vorzugsweise, dass die nichtleitende Schicht (10) aus einem thermisch aktivierbaren Kleber, insbesondere einer thermisch aktivierbaren Klebefolie, besteht und dass die Aktivierungswärme den Kleber bzw. die Klebefolie aktiviert, weiter vorzugsweise, dass die Aktivierungswärme so gering ist, dass sie die leitende Schicht (11) nicht aufschmilzt.

14. Verfahren nach einem der Ansprüche 11 bis 13, **dadurch gekennzeichnet, dass** in einem anschließenden Schritt die Leiterplatte (1) mit mindestens einem elektronischen Bauelement (2) bestückt wird und in einem Lötprozess gelötet wird und dass während des Lötprozesses die leitende Schicht (11) durch die auf den Lötprozess zurückgehende Wärmeeinwirkung aufgeschmolzen wird.
